# EUROPEAN PATENT SPECIFICATION

(11) **EP 3 923 426 B1**
(45) Date of publication and mention of the grant of the patent: **26.08.2026**
(21) Application number: 21178799.9
(22) Date of filing: 10.06.2021
(51) Int. Cl.: H10H 20/825, H10H 20/80, H01S 5/183, H01S 5/042

(54) **VERTICAL CAVITY LIGHT-EMITTING ELEMENT**
LICHTEMITTIERENDES ELEMENT MIT VERTIKALEM RESONATOR
ÉLÉMENT D'ÉMISSION DE LUMIÈRE À CAVITÉ VERTICALE

(30) Priority: 12.06.2020 JP 2020102539
(43) Date of publication of application: 15.12.2021
(73) Proprietor: STANLEY ELECTRIC CO., LTD., Tokyo 153-8636 (JP)
(72) Inventor: KURAMOTO, Masaru, Tokyo, 153-8636 (JP)
(74) Representative: Wimmer, Hubert

(56) References cited:
- EP-A2- 2 446 486
- WO-A1-2020/075428
- WO-A1-2021/140871
- JP-A- 2011 029 607
- US-A1- 2018 226 771
- US-A1- 2020 127 442

## Description

### BACKGROUND OF THE INVENTION

### 1. FIELD of the Invention

The present invention relates to a vertical cavity light-emitting element, such as a vertical cavity surface emitting laser (VCSEL).

### 2. Description of the Related Art

Conventionally, as one of the semiconductor lasers, there has been known a vertical cavity-type semiconductor surface emitting laser (hereinafter also simply referred to as a surface emitting laser) including a semiconductor layer that emits a light by application of voltage and multilayer reflectors opposed to one another with the semiconductor layer interposed therebetween. For example, JP-A-2017-98328 discloses a surface emitting laser that uses a nitride semiconductor.

For example, in a vertical cavity light-emitting element, such as a surface emitting laser, an insulating film that defines a light emission region is formed on a semiconductor layer upper surface, and a transmissive electrode film, such as ITO, electrically in contact with the semiconductor layer is formed on the insulating film.

For example, JP-A-2017-98328 discloses a vertical cavity light-emitting element in which an opening is formed in a region corresponding to a light emission region of the semiconductor layer and a transmissive electrode film of ITO is formed on an insulating film formed so as to surround the light emission region. In the vertical cavity light-emitting element of JP-A-2017-98328, the transmissive electrode film is formed to generate a level difference at an open-end portion of the insulating film.

However, when the level difference is generated in the transmissive electrode film as described above, there may be a case where a failure, such as a crack, occurs in this level difference portion of the transmissive electrode during a long period of energization to cause an increased driving voltage and/or a defect of short circuit/open circuit.

US 2018/226771 A1 was used as a basis for the preamble of the independent claims and discloses a vertical-cavity light-emitting element which includes: a first reflector; a semiconductor structure layer including a first semiconductor layer, an active layer, a second semiconductor layer, and a third semiconductor layer that are sequentially provided on the first reflector; a transparent electrode on the third semiconductor layer; and a second reflector on the transparent electrode and interposes the structure layer with the first reflector. The third semiconductor layer has a mesa structure to protrude on the second semiconductor layer and be covered by the transparent electrode. The light emitting element further includes a current confining layer including: an insulating film provided in the second semiconductor layer to surround the mesa structure and be in contact with the transparent electrode, the insulating film being an oxide of the second semiconductor layer; and an insulating layer on the insulating film to surround the mesa structure and define a through opening.

WO 2021/140871 A1 forms part of the prior art under Art. 54 (3) EPC and discloses a vertical-resonator-type light-emitting element that has: a substrate; a first multilayer film reflection mirror formed on the substrate; a semiconductor structure layer that includes a first semiconductor layer of a first electrically conductive type formed on the first multilayer film reflection mirror, a light-emitting layer formed on the first semiconductor layer, and a second semiconductor layer of a second electrically conductive type opposite to the first electrically conductive type and formed on the light-emitting layer; an electrode layer that is formed on the top surface of the semiconductor structure layer, and that is in electrical contact with the second semiconductor layer of the semiconductor structure layer in one region of the top surface; and a second multilayer film reflection mirror that is formed to cover the one region on the electrode layer, and constitutes a resonator with the first multilayer film reflection mirror, the semiconductor structure layer having one recess structure that includes one or more recesses that penetrate the light-emitting layer from the top surface in a region surrounding the one region.

US 2020/127442 A1 discloses a vertical-cavity surface-emitting laser (VCSEL) which includes a p-type distributed Bragg reflector (p-DBR) layer and a p-type ohmic (p-ohmic) contact layer adjacent to the p-DBR layer. The p-DBR layer may include an oxide aperture and the p-ohmic contact layer may have an opening that is aligned with the oxide aperture. The opening may be filled with a dielectric material. A metal layer may be coupled to the p-ohmic contact layer and encapsulate the dielectric material.

EP 2 446 486 A2 discloses a semiconductor structure comprising a III-nitride light emitting layer disposed between an n-type region and a p-type region. A contact disposed on the p-type region includes a transparent conductive material in direct contact with the p-type region, a reflective metal layer, and a transparent insulating material disposed between the transparent conductive layer and the reflective metal layer. In a plurality of openings in the transparent insulating material, the transparent conductive material is in direct contact with the reflective metal layer.

JP 2011-029607 A discloses a vertical resonator type surface-emitting laser. In order to provide a high-output and long-lifetime vertical resonator type surface-emitting laser, having a low threshold current by facilitating supply of current to an active region, the vertical resonator type surface-emitting laser includes an insulation layer having an opening on at least one surface of a nitride semiconductor layer including an n-type semiconductor layer, an active layer and a p-type semiconductor layer; a translucent electrode formed on the insulation layer to cover the opening; and a reflecting mirror formed on the opening through the translucent electrode and formed of a dielectric material wherein a conductive material is arranged between the insulation layer and the reflecting mirror.

### SUMMARY OF THE INVENTION

The present invention has been made in consideration of the above-described points and it is an object to provide a long-life vertical cavity light-emitting element by suppressing an increase of a driving voltage during a long period of energization.

A vertical cavity light-emitting element according to the present invention is provided as set forth in claim 1. Preferred embodiments of the present invention may be gathered from the dependent claims.

### BRIEF DESCRIPTION OF THE DRAWINGS

Fig. 1 is a perspective view of a surface emitting laser according to Embodiment 1;
Fig. 2 is a top view of the surface emitting laser according to Embodiment 1;
Fig. 3 is a cross-sectional view of the surface emitting laser according to Embodiment 1;
Fig. 4 is a cross-sectional view of a surface emitting laser according to Modification 1 of Embodiment 1;
Fig. 5 is a cross-sectional view of a surface emitting laser according to Modification 2 of Embodiment 1;
Fig. 6 is a top view of a surface emitting laser according to an example (Embodiment 2) useful for understanding the invention, but not falling under the scope of the invention;
Fig. 7 is a cross-sectional view of a surface emitting laser according to the example of Embodiment 2;
Fig. 8 is a perspective view of a surface emitting laser according to an example (Embodiment 3) useful for understanding the invention, but not falling under the scope of the invention;
Fig. 9 is a cross-sectional view of the surface emitting laser according to the example of Embodiment 3;
Fig. 10 is a cross-sectional view of a surface emitting laser according to Modification 3 of Embodiment 1; and
Fig. 11 is a cross-sectional view of a surface emitting laser according to Modification 4 of Embodiment 1.

### DETAILED DESCRIPTION OF THE INVENTION

The following describes embodiments of the present invention in detail. While in the following description, a description will be made using a semiconductor surface emitting laser element as an example (a semiconductor laser), the present invention is applicable, not only to a surface emitting laser, but also to various kinds of vertical cavity light-emitting elements, such as a vertical cavity-type light-emitting diode.

### (Embodiment 1)

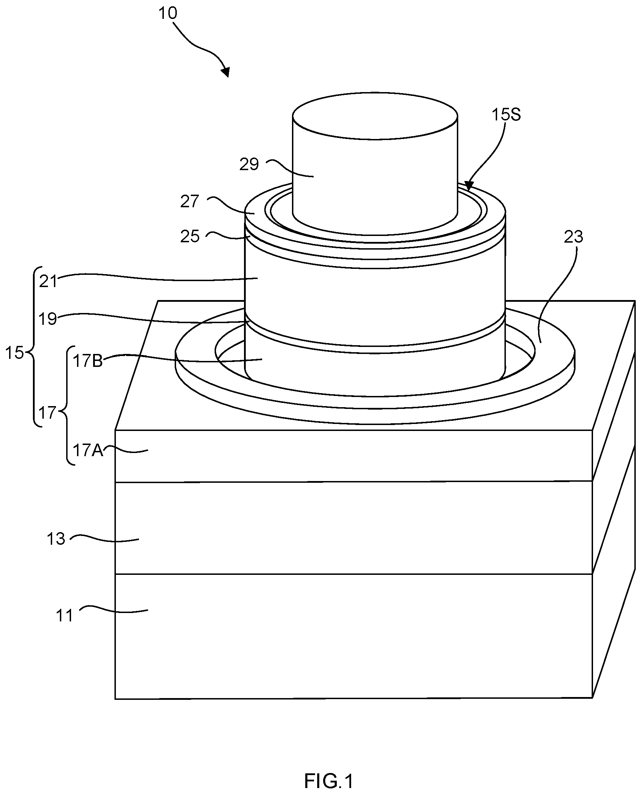

Fig. 1 is a perspective view of a vertical cavity surface emitting laser (VCSEL, hereinafter also simply referred to as a surface emitting laser) 10 according to Embodiment 1.

A substrate 11 is a gallium-nitride-based semiconductor substrate, for example, a GaN substrate. The substrate 11 is, for example, a substrate with a rectangular upper surface shape. On the substrate 11, a first multilayer reflector 13 made of a semiconductor layer that has been grown on the substrate 11 is formed.

The first multilayer reflector 13 is a semiconductor multilayer reflector in which a low refractive-index semiconductor film having a composition of AlInN and a high refractive-index semiconductor film having a GaN composition and having a refractive index higher than that of the low refractive-index semiconductor film are alternately laminated. In other words, the first multilayer reflector 13 is a distributed Bragg reflector (DBR) made of a semiconductor material. For example, on an upper surface of the substrate 11, a buffer layer having a GaN composition is disposed, and alternately forming films of the high refractive-index semiconductor film and the low refractive-index semiconductor film described above on the buffer layer forms the first multilayer reflector 13.

Note that the upper surface of the substrate 11, that is, the surface on which the buffer layer having the GaN composition is disposed is preferred to be a C-plane or a surface offset by within 0.5° from the C-plane. This is for providing, for example, satisfactory crystallinity of a semiconductor structure layer 15, which will be described later.

The semiconductor structure layer 15 is a laminated structure made of a plurality of semiconductor layers formed on the first multilayer reflector 13. The semiconductor structure layer 15 has an n-type semiconductor layer (a first semiconductor layer) 17 as a first conductivity type formed on the first multilayer reflector 13, a light-emitting layer (or an active layer) 19 formed on the n-type semiconductor layer 17, and a p-type semiconductor layer (a second semiconductor layer) 21 as a second conductivity type formed on the active layer 19.

The n-type semiconductor layer 17 is a semiconductor layer formed on the first multilayer reflector 13. The n-type semiconductor layer 17 is a semiconductor layer that has a GaN composition and is doped with Si as n-type impurities. The n-type semiconductor layer 17 has a prismatic-shaped lower portion 17A and a column-shaped upper portion 17B disposed on the lower portion 17A. Specifically, for example, the n-type semiconductor layer 17 has the column-shaped upper portion 17B projecting from an upper surface of the prismatic-shaped lower portion 17A. In other words, the n-type semiconductor layer 17 has a mesa-shaped structure including the upper portion 17B.

The active layer 19 is a layer that is formed on the upper portion 17B of the n-type semiconductor layer 17 and has a quantum well structure including a well layer having an InGaN composition and a barrier layer having a GaN composition. In the surface emitting laser 10, a light is generated in the active layer 19.

The p-type semiconductor layer 21 is a semiconductor layer having a GaN composition formed on the active layer 19. The p-type semiconductor layer 21 is doped with Mg as p-type impurities. That is, in the semiconductor structure layer 15, the n-type semiconductor layer 17 includes the mesa-shaped structure on the upper surface, and the active layer 19 and the p-type semiconductor layer 21 are laminated on the mesa-shaped structure.

An n-electrode 23 as an-electrode layer is a metal electrode disposed on an upper surface of the lower portion 17A of the n-type semiconductor layer 17 and electrically connected to the n-type semiconductor layer 17. The n-electrode 23 is formed into a ring shape so as to surround the upper portion 17B of the n-type semiconductor layer 17. In other words, the n-electrode 23 that is electrically in contact with the n-type semiconductor layer 17 on the upper surface existing around the mesa-shaped structure of the n-type semiconductor layer 17 is formed. Note that the n-electrode 23 may be, what is called, an-electrode layer formed into a layer form on the upper surface of the n-type semiconductor layer 17.

An insulating layer 25 as a transmissive insulating layer is a layer made of an insulator formed on the p-type semiconductor layer 21. The insulating layer 25 is formed of a substance having a refractive index lower than that of a material forming the p-type semiconductor layer 21, such as SiO₂. The insulating layer 25 is formed into a ring shape on the p-type semiconductor layer 21 and is provided with an opening (not illustrated) that exposes the p-type semiconductor layer 21 at a central portion.

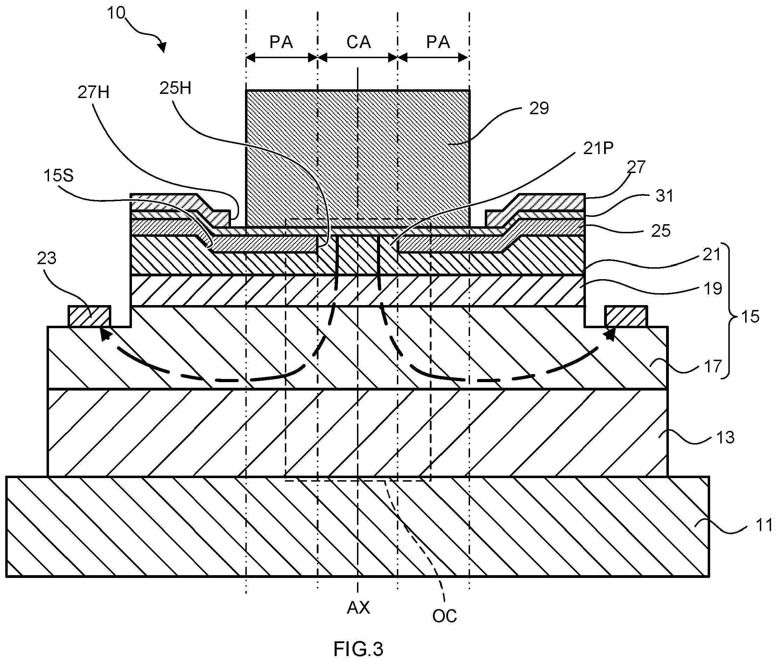

A p-electrode 27 as a metal conductor layer is a metal electrode formed on the insulating layer 25. The p-electrode 27 is electrically connected to an upper surface of the p-type semiconductor layer 21 exposed from the above-described opening of the insulating layer 25 via a light transmissive electrode layer 31 (described later in Fig. 3) made of a metal oxide film, such as ITO or IZO.

A second multilayer reflector 29 is a dielectric multilayer reflector in which a low refractive index dielectric film made of SiO₂ and a high refractive index dielectric film made of Nb₂O₅ and having a refractive index higher than that of the low refractive index dielectric film are alternately laminated. In other words, the second multilayer reflector 29 is a distributed Bragg reflector (DBR) made of a dielectric material.

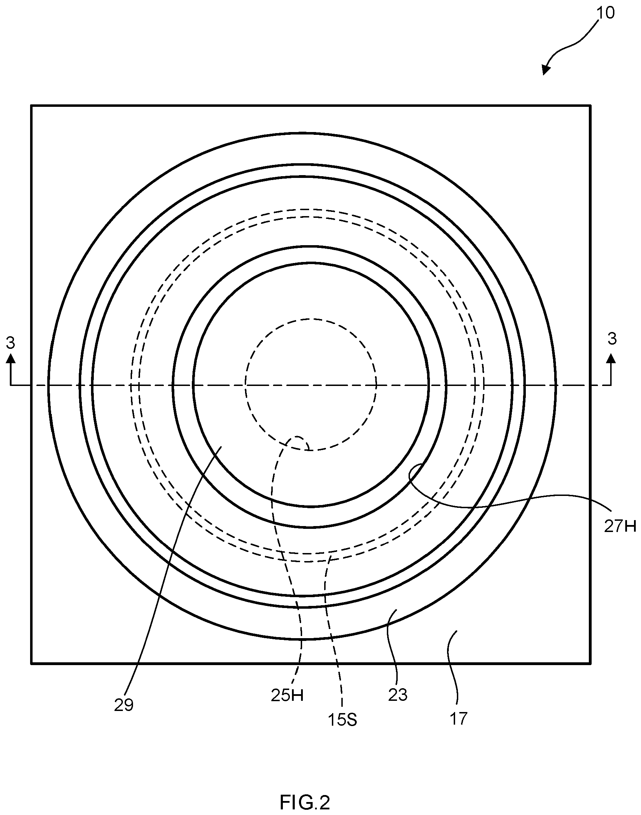

Fig. 2 is a top view of the surface emitting laser 10. As described above, the surface emitting laser 10 has the semiconductor structure layer 15 including the n-type semiconductor layer 17 formed on the substrate 11 having the rectangular upper surface shape, the active layer 19 having the circular-shaped upper surface, and the p-type semiconductor layer 21 (see Fig. 1). On the p-type semiconductor layer 21, the insulating layer 25 and the p-electrode 27 are formed. On the p-electrode 27, the second multilayer reflector 29 is formed.

The insulating layer 25 has an opening 25H as a circular-shaped opening that exposes the p-type semiconductor layer 21 of the above-described insulating layer 25. As illustrated in Fig. 2, the opening 25H is formed at the center of the insulating layer 25 when viewed from an upper side of the surface emitting laser 10 and is covered with the second multilayer reflector 29 when viewed from the upper side of the surface emitting laser 10. In other words, the opening 25H is covered with the second multilayer reflector 29 in the upper surface of the p-type semiconductor layer 21. Yet in other words, the opening 25H is formed in a region opposed to a lower surface of the second multilayer reflector 29 of the insulating layer 25.

The p-electrode 27 is formed at the center of the insulating layer 25 when viewed from the upper side of the surface emitting laser 10 and has an opening 27H that surrounds the opening 25H. That is, the opening 27H is an opening larger than the opening 25H. For example, the opening 27H has a circular shape concentric to the shape of the opening 25H.

As illustrated in Fig. 2, a level difference 15S in a circular ring shape is formed on the upper surface of the p-type semiconductor layer 21, that is, the upper surface of the semiconductor structure layer 15. The level difference 15S is formed in an outside region of the opening 25H and the opening 27H. That is, the level difference 15S is a level difference provided in a ring shape when viewed in a direction perpendicular to an in-plane direction of the semiconductor structure layer 15.

In this embodiment, the level difference 15S is formed outside the second multilayer reflector 29 on the upper surface of the p-type semiconductor layer 21.

Fig. 3 is a cross-sectional view of the surface emitting laser 10 taken along the line 3-3 in Fig. 2. As described above, the surface emitting laser 10 has the substrate 11 as the GaN substrate, and the first multilayer reflector 13 is formed on the substrate 11. Note that a lower surface of the substrate 11 may be applied with an AR coating where Nb₂O₅ and SiO₂ are laminated.

The semiconductor structure layer 15 is formed on the first multilayer reflector 13. The semiconductor structure layer 15 is a laminated body made by forming the n-type semiconductor layer 17, the active layer 19, and the p-type semiconductor layer 21 in this order.

The level difference 15S formed on the semiconductor structure layer 15 is formed to surround a projecting portion 21P projecting at the center on the upper surface of the p-type semiconductor layer 21.

The insulating layer 25 is formed to cover the upper surface of the p-type semiconductor layer 21. The insulating layer 25 is made of a material having a refractive index lower than that of the p-type semiconductor layer 21 as described above. The insulating layer 25 has the opening 25H that exposes the projecting portion 21P. For example, as illustrated in Fig. 2, the opening 25H is in a circular shape. For example, the opening 25H and the projecting portion 21P have similar shapes, and an inner surface of the opening 25H is in contact with an outer surface of the projecting portion 21P. In a region inside the level difference 15S, an upper surface of the insulating layer 25 and an upper surface of the projecting portion 21P are formed to have the same height. That is, in the region inside the level difference 15S, the upper surface of the insulating layer 25 and the upper surface of the projecting portion 21P have a flatness characteristic. Note that the same height referred to here is not perfectly the same height and may include unevenness and/or level differences in a range that does not affect its emitted light from the active layer 19, that is, a standing wave (a laser light) generated between the first multilayer reflector 13 and the second multilayer reflector 29.

The light transmissive electrode layer 31 is a layer made of a conductive body having translucency formed to cover the insulating layer 25 and the projecting portion 21P exposed from the opening 25H of the insulating layer 25. That is, the light transmissive electrode layer 31 is electrically in contact with the p-type semiconductor layer 21 in a region exposed by the opening 25H on the upper surface of the p-type semiconductor layer 21. The light transmissive electrode layer 31 is formed of a metal oxide having translucency relative to an emitted light from the active layer 19, such as ITO or IZO. The light transmissive electrode layer 31 is formed to transfer shapes of the upper surface of the insulating layer 25 and the upper surface of the projecting portion 21P on the lower surface side. That is, the light transmissive electrode layer 31 has a level difference at a position corresponding to the level difference 15S.

The p-electrode 27 is the metal electrode as described above and is formed to cover the light transmissive electrode layer 31. That is, the p-electrode 27 is electrically in contact with the light transmissive electrode layer 31. Accordingly, the p-electrode 27 is electrically in contact with or electrically connected to the p-type semiconductor layer 21 via the light transmissive electrode layer 31 in a region exposed by the opening 25H on the upper surface of the p-type semiconductor layer 21. The p-electrode 27 has the opening 27H that exposes the light transmissive electrode layer 31 at the center. The opening 27H is an opening with a width (or a diameter) larger than that of the opening 25H. As illustrated in Fig. 3, the p-electrode 27 is formed to cover the level difference 15S.

In the surface emitting laser 10, the first multilayer reflector 13 has reflectivity slightly lower than that of the second multilayer reflector 29. Accordingly, a part of the light resonated between the first multilayer reflector 13 and the second multilayer reflector 29 transmits through the first multilayer reflector 13 and the substrate 11 to be taken out to the outside.

Here, an operation of the surface emitting laser 10 will be described. In the surface emitting laser 10, when a voltage is applied between the n-electrode 23 and the p-electrode 27, a current flows in the semiconductor structure layer 15 as indicated by the two-dot chain bold line in the drawing, and a light is emitted from the active layer 19. The light emitted from the active layer 19 is repeatedly reflected between the first multilayer reflector 13 and the second multilayer reflector 29 to become a resonant state (to laser oscillate).

In the surface emitting laser 10, the current is injected to the p-type semiconductor layer 21 only from a portion exposed by the opening 25H. Since the p-type semiconductor layer 21 is considerably thin, the current does not spread in the in-plane direction, that is, in a direction along a surface of the semiconductor structure layer 15 in the p-type semiconductor layer 21. Accordingly, in the surface emitting laser 10, the current is supplied only to a region immediately below the opening 25H in the active layer 19 and the light is emitted only from this region. That is, in the surface emitting laser 10, the opening 25H has a current confinement structure that restricts a supply range of the current in the active layer 19.

As described above, in this embodiment, the first multilayer reflector 13 has a reflectivity slightly lower than that of the second multilayer reflector 29. Accordingly, a part of the light resonated between the first multilayer reflector 13 and the second multilayer reflector 29 transmits through the first multilayer reflector 13 and the substrate 11 to be taken out to the outside. Thus, the surface emitting laser 10 emits the light in the direction perpendicular to the lower surface of the substrate 11 and the in-plane directions of the respective layers of the semiconductor structure layer 15 from the lower surface of the substrate 11.

Note that the projecting portion 21P of the p-type semiconductor layer 21 of the semiconductor structure layer 15 and the opening 25H of the insulating layer 25 define a luminescence center as the center of the light emission region in the active layer 19 and define the center axis (a luminescence center axis) AX of a resonator OC. The center axis AX of the resonator OC passes through the center of the projecting portion 21P of the p-type semiconductor layer 21 and extends along the direction perpendicular to the in-plane direction of the semiconductor structure layer 15.

Note that the light emission region of the active layer 19 is, for example, a region having a predetermined width through which a light having a predetermined intensity or more is emitted in the active layer 19, and its center is the luminescence center. For example, the light emission region of the active layer 19 is a region to which a current having a predetermined density or more is injected in the active layer 19, and its center is the luminescence center. A straight line perpendicular to the upper surface of the substrate 11 or the in-plane directions of the respective layers of the semiconductor structure layer 15 passing through the luminescence center is the center axis AX. The luminescence center axis AX is a straight line that extends along a resonator length direction of the resonator OC constituted of the first multilayer reflector 13 and the second multilayer reflector 29. The center axis AX corresponds to an optical axis of a laser light emitted from the surface emitting laser 10.

Here, an exemplary configuration of the respective layers of the first multilayer reflector 13, the semiconductor structure layer 15, and the second multilayer reflector 29 in the surface emitting laser 10 will be described. In this embodiment, the first multilayer reflector 13 is made of a GaN base layer of 1 µm thickness and 42 pairs of n-GaN layers (thick 45 nm) and AlInN layers (thick 50 nm) formed on the upper surface of the substrate 11.

The n-type semiconductor layer 17 is an n-GaN layer doped with Si having a layer thickness of 1580 nm. The active layer 19 is made of an active layer in a multiple quantum well structure in which four pairs of InGaN layers of 4 nm and GaN layers of 5 nm are laminated and is adjusted to have a peak of spectrum of emission emitted from the active layer 19 of approximately 440 nm. On the active layer 19, an electronic barrier layer of AlGaN doped with Mg is formed and the p-type semiconductor layer 21 made of p-GaN layer of 50 nm is formed on the electronic barrier layer. The second multilayer reflector 29 is a lamination of 10.5 pairs of Nb₂O₅ of 45 nm and SiO₂ of 76 nm. The resonant wavelength in this case was 440 nm.

The p-type semiconductor layer 21 has a layer thickness of 50 nm in the projecting portion 21P and a layer thickness of 30 nm in a region from an outer peripheral end of the projecting portion 21P to the level difference 15S. The insulating layer 25 made of SiO₂ has a layer thickness of 20 nm, that is, in the region from the inner peripheral end in contact with a side surface of the projecting portion 21P of the insulating layer 25 to the level difference 15S, the upper surface of the insulating layer 25 is configured to be arranged at a height position identical to that of the upper surface of the projecting portion 21P of the p-type semiconductor layer 21.

The light transmissive electrode layer 31 formed on the semiconductor structure layer 15 is a layer made of ITO of 20 nm, and the second multilayer reflector 29 is formed by interposing a spacer layer of Nb₂O₅ of 40 nm on the light transmissive electrode layer 31 and the p-electrode 27. The p-electrode 27 is a lamination of Ti (100 nm), Pt (100 nm), and Au (500 nm) in this order.

Note that the p-type semiconductor layer 21, the insulating layer 25, the light transmissive electrode layer 31, and the p-electrode 27 in the portion of the level difference 15S are level differences having an inclination with respect to the center axis AX of the surface emitting laser 10. An inclination angle of this inclination is preferred to be 45° or more with respect to the center axis AX. In other words, this inclination angle is preferred to be 45° or less with respect to the upper surface of the semiconductor structure layer 15. Providing the inclination in this level difference ensures achieving improved reliability over a long period, such as a crack resistance of the light transmissive electrode layer 31, during a long period of energization.

A back surface of the substrate 11 is a polished surface, and two layers of AR coatings of Nb₂O₅ and SiO₂ are formed on this polished surface.

Note that the above-described configuration of the surface emitting laser 10 of this embodiment is merely an example.

The following describes optical features of an inside of the surface emitting laser 10. As described above, in the surface emitting laser 10, the insulating layer 25 has a refractive index lower than that of the p-type semiconductor layer 21. Layer thicknesses of other layers between the first multilayer reflector 13 and the second multilayer reflector 29 are the same at any positions in plane insofar as in the same layer.

Accordingly, an equivalent refractive index (an optical distance between the first multilayer reflector 13 and the second multilayer reflector 29, and corresponds to a resonant wavelength) in the resonator OC formed between the first multilayer reflector 13 and the second multilayer reflector 29 of the surface emitting laser 10 differs in a central region CA as one region in a column shape having the upper surface defined by the opening 25H and in a peripheral region PA as another region in a pipe shape around the central region CA by a difference in refractive indexes between the p-type semiconductor layer 21 and the insulating layer 25.

Specifically, the equivalent refractive index in the peripheral region PA is lower than the equivalent refractive index in the central region CA, that is, an equivalent resonant wavelength in the central region CA is longer than an equivalent resonant wavelength in the peripheral region PA between the first multilayer reflector 13 and the second multilayer reflector 29. Note that, as described above, somewhere the light is emitted in the active layer 19 is the region immediately below the projecting portion 21P. That is, the light emission region where the light is emitted in the active layer 19 is a portion overlapping with the central region CA in the active layer 19.

Thus, in the surface emitting laser 10, the central region CA including the light emission region of the active layer 19 and the peripheral region PA that surrounds the central region CA and has the refractive index lower than that of the central region CA are formed. This reduces an optical loss caused by diffusion (radiation) of the standing wave within the central region CA into the peripheral region PA. That is, a large quantity of light remains in the central region CA and a laser light is taken out to the outside in this state. Accordingly, the large quantity of light concentrates in the central region CA in the peripheral area of the luminescence center axis AX of the resonator OC to ensure generating and emitting a laser light with high output power and high density.

As described above, the surface emitting laser 10 according to Embodiment 1 is formed to generate the level difference in the light transmissive electrode layer 31. In other words, the level difference 15S forms the level difference in the light transmissive electrode layer 31. Afterwards, the p-electrode 27 is formed to cover the level difference.

As described above, the surface emitting laser 10 according to Embodiment 1 includes the substrate 11, the first multilayer reflector 13, the semiconductor structure layer 15, the light transmissive electrode layer 31, the p-electrode 27, and the second multilayer reflector 29. The substrate 11 is a gallium-nitride-based semiconductor. The first multilayer reflector 13 is made of a nitride semiconductor formed on the substrate 11. The semiconductor structure layer 15 includes the n-type semiconductor layer 17, the active layer 19, and the p-type semiconductor layer 21. The n-type semiconductor layer 17 is made of a nitride semiconductor having the first conductivity type and formed on the first multilayer reflector 13. The active layer 19 is made of a nitride semiconductor formed on the n-type semiconductor layer 17. The p-type semiconductor layer 21 is formed on the active layer 19 and made of a nitride semiconductor having the p-type conductivity type opposite of the n-type conductivity type. The light transmissive electrode layer 31 is formed on the upper surface of the p-type semiconductor layer 21. The light transmissive electrode layer 31 is electrically in contact with the p-type semiconductor layer 21 in the central region CA of the p-type semiconductor layer 21 and is insulated from the p-type semiconductor layer 21 in the peripheral region PA that is other than the central region CA and surrounds the central region CA. The p-electrode 27 is formed on the upper surface of the light transmissive electrode layer 31 above the peripheral region PA. The second multilayer reflector 29 is formed to cover the central region CA on the light transmissive electrode layer 31. The second multilayer reflector 29 configures the resonator OC between the first multilayer reflector 13 and the second multilayer reflector 29. The peripheral region PA on the upper surface of the semiconductor structure layer 15 includes the level difference 15S. The p-electrode 27 is formed to cover the light transmissive electrode layer 31 on the level difference 15S.

The level difference 15S has the inclined surface having the angle with respect to the upper surface of the semiconductor structure layer 15 of 45° or less. The n-type semiconductor layer 17 has the mesa-shaped structure on the upper surface, the active layer 19 and the p-type semiconductor layer are laminated on the mesa-shaped structure, and the surface emitting laser 10 includes the n-electrode 23 that is electrically in contact with the n-type semiconductor layer 17 on the upper surface of the n-type semiconductor layer 17 existing around the mesa-shaped structure.

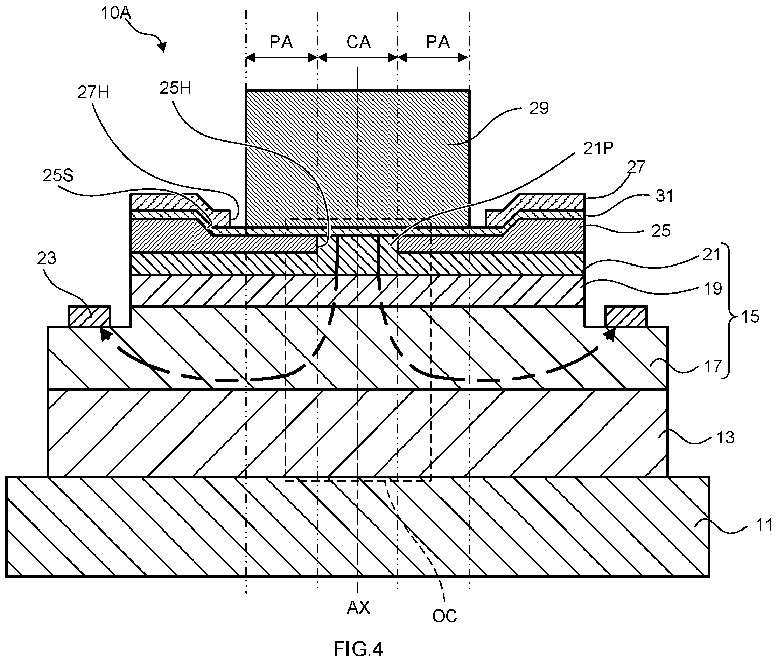

Fig. 4 illustrates a cross-sectional view of a surface emitting laser 10A according to Modification 1 of Embodiment 1.

In Fig. 3, the p-type semiconductor layer 21 is configured such that the ring-shaped region surrounding the projecting portion 21P (equivalent to the peripheral region PA when viewed from the upper surface) is etched and the insulating layer 25 is formed outside the ring-shaped region and the level difference 15S and on the upper surface of the p-type semiconductor layer 21 in order to form the level difference 15S. However, alternatively, as illustrated in Fig. **4****,** the p-type semiconductor layer 21 may be configured such that a whole surface other than the projecting portion 21P is etched, the insulating layer 25 is formed in this region, and a level difference 25S is formed in the insulating layer 25.

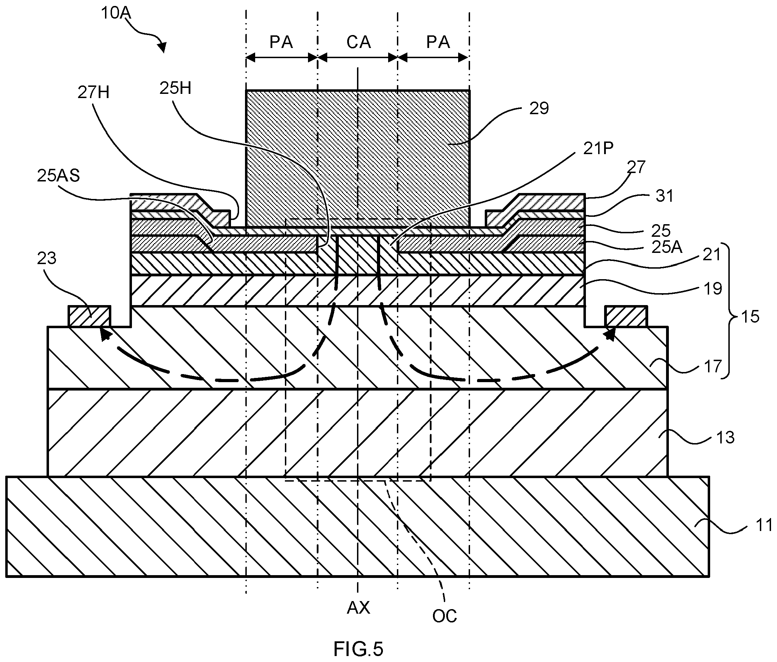

As illustrated in Fig. 5, for the insulating layer 25, a first insulating layer 25A for forming a level difference (a level difference 25AS in the drawing) may be laminated and the additional insulating layer 25 may be further laminated on upper surfaces of the ring-shaped region surrounding the projecting portion 21P of the p-type semiconductor layer 21 and the first level difference 25A. Note that the insulating layer 25A for forming the level difference 25AS may be an insulating layer made of a material different from that of the insulating layer 25.

Note that when it is formed so as not to generate a level difference in the transmissive electrode, an electrostatic capacity in a current path of the semiconductor layer increases to possibly reduce a modulation rate. The more the electrostatic capacity increases, the more a heat generation amount of the semiconductor layer during driving increases, and thus, the semiconductor layer melts to cause a defect, such as a short circuit, in some cases.

That is, increasing a distance between the p-electrode 27 and the surface of the p-type semiconductor layer 21 by forming this level difference ensures reducing the electrostatic capacity between the p-electrode 27 and the surface of the p-type semiconductor layer 21 when the surface emitting laser 10 is driven, and thus, the reduction in modulation rate can be prevented. This reduction of the electrostatic capacity ensures reducing the heat generation amount during driving, and thus, the defect, such as melting of the semiconductor structure layer 15, can be also prevented from occurring.

The light transmissive electrode layer 31 on the level difference 15S is covered with the p-electrode 27 as the metal layer. This ensures preventing a failure, such as a crack, from occurring in the level difference portion of the light transmissive electrode layer 31 during a long period of energization. Even if a crack occurs in the level difference portion of the light transmissive electrode layer 31 during a long period of energization, since the p-electrode 27 is formed to cover the level difference, the conduction between the p-electrode 27 and the p-type semiconductor layer 21 are maintained. Accordingly, even when a crack occurs in the level difference portion of the light transmissive electrode layer 31, it is possible to prevent a failure, such as an open circuit, from occurring.

Accordingly, with Embodiment 1, it is possible to prevent an increased driving voltage and/or a defect of short circuit/open circuit, during a long period of energization from occurring, and thus, the long-life vertical cavity-type surface emitting laser 10 can be provided.

### (Embodiment 2)

The following describes a surface emitting laser 20 as Embodiment 2 of the present invention.

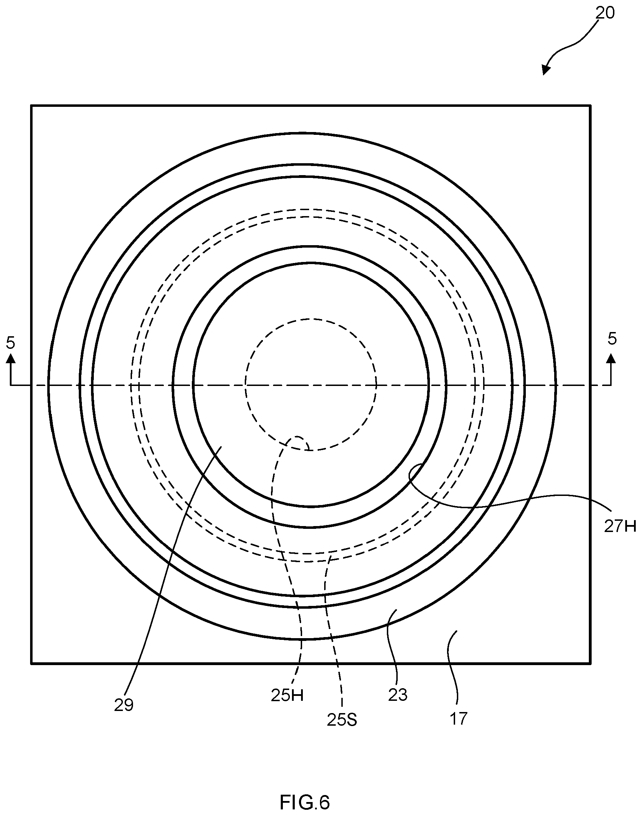

Fig. 6 illustrates a top view of the surface emitting laser 20 of an example corresponding to Embodiment 2, which is useful for understanding the invention, but does not fall under the scope of the invention.

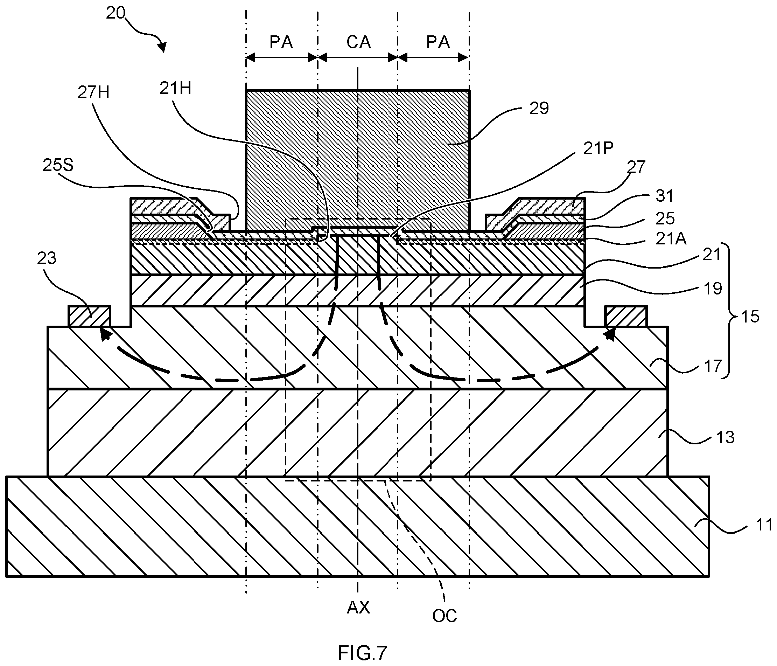

Fig. 7 is a cross-sectional view taken along the line 5-5 in Fig. 6 of the surface emitting laser 20.

The surface emitting laser 20 has a basically similar configuration to that of the surface emitting laser 10 of Embodiment 1 and has a similar appearance. However, the surface emitting laser 20 is different from the surface emitting laser 10 in that the level difference is not disposed outside the central region CA of the semiconductor structure layer 15 and the level difference is formed by the insulating layer 25 formed outside the central region CA. It is also different from the surface emitting laser 10 in that a deactivation region layer 21A in which the p-type impurities are deactivated is disposed outside the projecting portion 21P of the p-type semiconductor layer 21.

The deactivation region layer 21A can be, for example, formed by dry etching with the region of the projecting portion 21P of the p-type semiconductor layer 21 remained. The semiconductor including impurities, such as the p-type semiconductor layer 21, has its surface roughened by dry etching. This deactivates the p-type impurities in the etched portion, and the deactivation region layer 21A is formed. In the deactivation region layer 21A, the p-type semiconductor layer 21 is partially removed by dry etching. In other words, the deactivation region layer 21A has an opening 21H as a circular-shaped opening that exposes the p-type semiconductor layer 21 of the deactivation region layer 21A. Note that an etching amount partially removed by dry etching in the deactivation region layer 21A is, for example, 4 nm.

The insulating layer 25 as the light transmissive insulator is formed outside the central region CA on the upper surface of the p-type semiconductor layer 21. The insulating layer 25 has the level difference 25S formed on an inner edge portion of the insulating layer 25. The light transmissive electrode layer 31 and the p-electrode 27 are formed to generate the level difference in a portion corresponding to the level difference 25S. That is, the p-electrode 27 is formed to cover the level difference portion of the light transmissive electrode layer 31 generated by the level difference 25S. Yet in other words, the p-electrode 27 is formed to cover an inner edge of the translucent insulating layer 25, that is, the portion of the level difference 25S via the light transmissive electrode layer 31.

Similarly to Embodiment 1 described above, increasing the distance between the p-electrode 27 and the surface of the p-type semiconductor layer 21 by forming the level difference 25S ensures reducing the electrostatic capacity between the p-electrode 27 and the p-type semiconductor layer 21 during driving of the surface emitting laser 20, and thus, the reduction in modulation rate can be prevented. This reduction in electrostatic capacity ensures reducing a heat generation amount during driving, and thus, a defect, such as melting of the semiconductor structure layer 15, can be prevented from occurring.

The light transmissive electrode layer 31 and the p-electrode 27 in the portion of the level difference 25S are preferred to be a level difference that has an inclination with respect to the center axis AX of the surface emitting laser 20. An inclination angle of the insulating layer 25 at the portion of the level difference 25S with respect to the center axis AX is preferred to be 45° or more. In other words, this inclination angle is preferred to be 45° or less with respect to the upper surface of the semiconductor structure layer 15. Disposing the inclination in this level difference ensures achieving improved reliability over a long period, such as a crack resistance, during a long period of energization of the light transmissive electrode layer film-formed on the level difference 25S of the insulating layer 25.

As described above, the surface emitting laser 20 according to Embodiment 2 includes the substrate 11, the first multilayer reflector 13, the semiconductor structure layer 15, the insulating layer 25, the light transmissive electrode layer 31, the p-electrode 27, and the second multilayer reflector 29. The substrate 11 is a gallium-nitride-based semiconductor. The first multilayer reflector 13 is made of a nitride semiconductor formed on the substrate 11. The semiconductor structure layer 15 includes the n-type semiconductor layer 17, the active layer 19, and the p-type semiconductor layer 21. The n-type semiconductor layer 17 is made of a nitride semiconductor having the n-type conductivity type formed on the first multilayer reflector 13. The active layer 19 is made of a nitride semiconductor formed on the n-type semiconductor layer 17. The p-type semiconductor layer 21 is formed on the active layer 19 and made of a nitride semiconductor having the p-type conductivity type opposite of the n-type conductivity type. The insulating layer 25 is formed on the upper surface of the p-type semiconductor layer 21. The insulating layer 25 is formed in the region that surrounds the central region CA of the p-type semiconductor layer 21. The light transmissive electrode layer 31 is formed across the upper surface of the p-type semiconductor layer 21 and the upper surface of the deactivation region layer 21A and in contact with the p-type semiconductor layer 21 in the central region CA. The p-electrode 27 is formed on the upper surface of the light transmissive electrode layer 31 above the peripheral region PA. The second multilayer reflector 29 is formed to cover the central region CA on the light transmissive electrode layer 31. The second multilayer reflector 29 configures the resonator OC between the first multilayer reflector 13 and the second multilayer reflector 29. The p-electrode 27 is formed to cover the inner edge of the insulating layer 25 via the light transmissive electrode layer 31.

The deactivation region layer 21A functions as a high resistance region having an electrical resistance higher than that of the p-type semiconductor layer 21. On the other hand, a region that is not etched, that is, the projecting portion 21P of the p-type semiconductor layer 21, which is the region not provided with the deactivation region layer 21A, functions as a low resistance region.

The p-type semiconductor layer 21 functions as a current confinement layer that confines a current path injected to the active layer 19. The projecting portion 21P of the p-type semiconductor layer 21 functions as a current injection region that injects the current to the active layer 19. On the other hand, the deactivation region layer 21A of the p-type semiconductor layer 21 functions as a non-current injection region that suppresses the injection of current to the active layer 19.

That is, in the surface emitting laser 20, the current is injected only from the portion exposed by the opening 21H to the p-type semiconductor layer 21. Since the p-type semiconductor layer 21 is considerably thin, the current hardly spreads in the in-plane direction, that is, in the direction along the in-plane of the semiconductor structure layer 15 within the p-type semiconductor layer 21. Accordingly, in the surface emitting laser 20, the current is supplied only to the region immediately below the opening 21H in the active layer 19, and the light is emitted only from this region. That is, in the surface emitting laser 20, the opening 21H has the current confinement structure that restricts a supply range of the current in the active layer 19.

Accordingly, in the surface emitting laser 20, when a voltage is applied between the n-electrode 23 and the p-electrode 27, a current flows within the semiconductor structure layer 15 as indicated by the two-dot chain bold line in the drawing, and the light is emitted from the active layer 19. The light emitted from the active layer 19 is repeatedly reflected between the first multilayer reflector 13 and the second multilayer reflector 29 to become the resonant state (to laser oscillate) .

As described above, a layer thickness in the central region CA (the low resistance region) of the p-type semiconductor layer 21 is greater than the layer thickness in the peripheral region PA (the high resistance region) of the p-type semiconductor layer 21.

Accordingly, an equivalent refractive index (an optical distance between the first multilayer reflector 13 and the second multilayer reflector 29, and corresponds to a resonant wavelength) in the resonator OC formed between the first multilayer reflector 13 and the second multilayer reflector 29 of the surface emitting laser 20 differs in the central region CA in a column shape having the upper surface defined by the opening 21H and in the peripheral region PA in a pipe shape around the central region CA by a difference in refractive indexes between the p-type semiconductor layer 21 and the insulating layer 25.

Specifically, the equivalent refractive index in the peripheral region PA is lower than the equivalent refractive index in the central region CA, that is, the equivalent resonant wavelength in the central region CA is longer than the equivalent resonant wavelength in the peripheral region PA between the first multilayer reflector 13 and the second multilayer reflector 29. Note that, as described above, where the light is emitted in the active layer 19 is the region immediately below the opening 21H. That is, the light emission region where the light is emitted in the active layer 19 is a portion overlapping with the central region CA in the active layer 19.

In Embodiment 2, it has been described the case where the high resistance region layer forming the current confinement structure is the deactivation region layer 21A in which the p-type semiconductor layer 21 is deactivated by dry etching. However, the configuration of the high resistance region is not limited to this. For example, as the high resistance region layer, a surface layer of a GaN layer on which a high resistance treatment is provided by ion implantation on the p-type semiconductor layer 21 may be used. For example, the high resistance region layer may be an insulating layer of, for example, SiO₂.

As described above, with Embodiment 2, the light transmissive electrode layer 31 on the level difference 25S is covered with the p-electrode 27 as a metal layer. This ensures preventing a failure, such as a crack, from occurring in the level difference portion of the light transmissive electrode layer 31 during a long period of energization. Even if a crack is generated in the level difference portion of the light transmissive electrode layer 31 during a long period of energization, since the p-electrode 27 is formed to cover the level difference, the conduction between the p-electrode 27 and the p-type semiconductor layer 21 are maintained. Accordingly, even when a crack occurs in the level difference portion of the light transmissive electrode layer 31, it is possible to prevent a failure, such as an open circuit, from occurring.

Accordingly, Embodiment 2 ensures preventing an increased driving voltage and/or a defect of short circuit/open circuit, during a long period of energization from occurring, and the long-life vertical cavity-type surface emitting laser 20 can be provided.

### (Embodiment 3)

The following describes a surface emitting laser 30 as Embodiment 3 of the present invention.

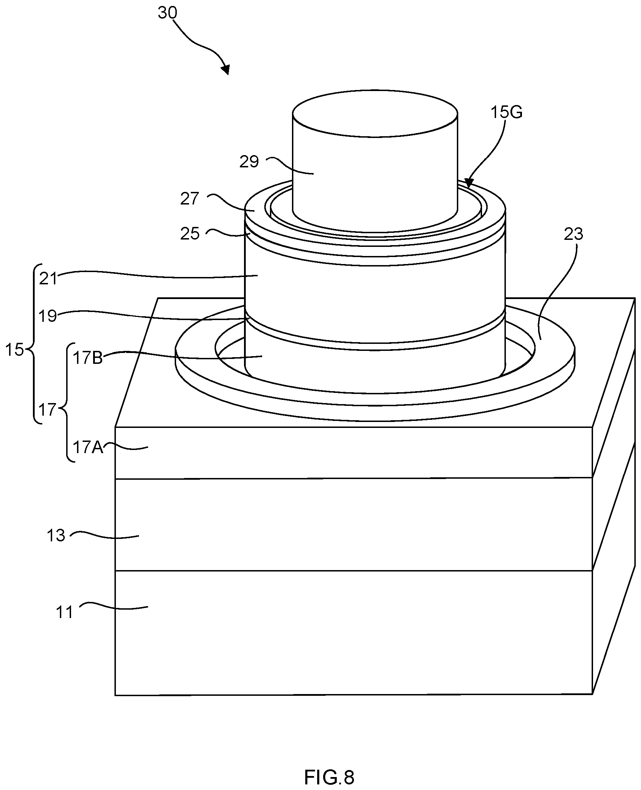

Fig. 8 illustrates a perspective view of the surface emitting laser 30 according to the example of Embodiment 3, which is useful to understand the invention but does not fall under the scope of the invention.

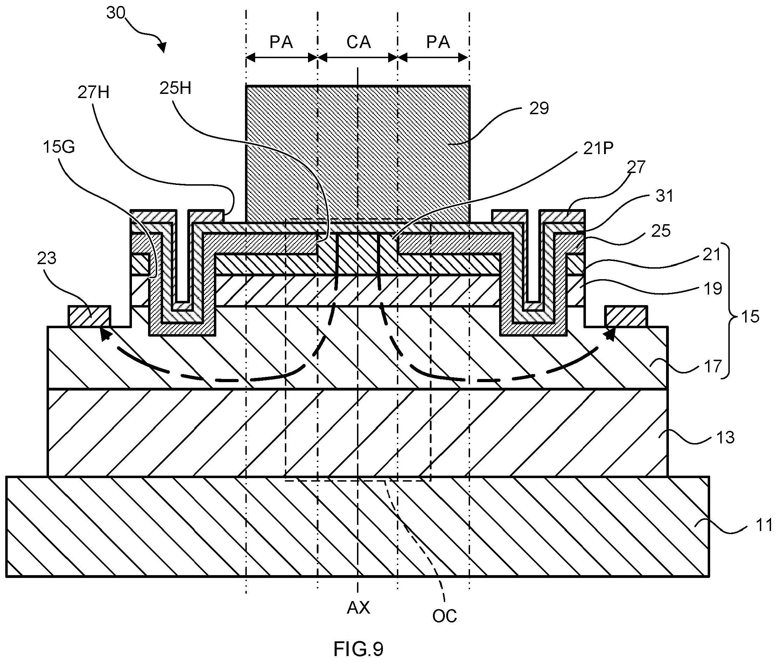

Fig. 9 illustrates a cross-sectional view of the surface emitting laser 30 cut along a cross section similar to the one illustrated in the above-described Embodiment 1.

While the surface emitting laser 30 has a basically similar configuration to that of the surface emitting laser 10 in Embodiment 1, it is different from the surface emitting laser 10 in that a circular ring-shaped groove 15G is formed outside the central region CA of the semiconductor structure layer 15.

As illustrated in Fig. 9, on the upper surface of the p-type semiconductor layer 21, that is, on the upper surface of the semiconductor structure layer 15, the circular ring-shaped groove 15G is formed. The groove 15G is formed in a region outside the opening 25H and the opening 27H. That is, the groove 15G is a groove arranged into a ring shape when viewed from the direction perpendicular to the in-plane direction of the semiconductor structure layer 15.

In this embodiment, the groove 15G is formed outside the second multilayer reflector 29 on the upper surface of the p-type semiconductor layer 21. That is, on the upper surface of the p-type semiconductor layer 21, the groove 15G is exposed from the peripheral region PA where the second multilayer reflector 29 is formed.

The groove 15G formed in the semiconductor structure layer 15 is formed to surround the projecting portion 21P projecting at the center of the upper surface of the p-type semiconductor layer 21, and passes through the active layer 19 from the upper surface of the p-type semiconductor layer 21 to reach the n-type semiconductor layer 17.

Thus, in the surface emitting laser 30 of Embodiment 3, the groove 15G is formed to pass through the active layer 19. In other words, the groove 15G forms a clearance in the active layer 19.

The insulating layer 25 is formed to cover the upper surface of the p-type semiconductor layer 21 and an inner surface of the groove 15G. The insulating layer 25 is made of a material having a refractive index lower than that of the p-type semiconductor layer 21 as described above. The insulating layer 25 has the opening 25H that exposes the projecting portion 21P. For example, as illustrated in Fig. 8, the opening 25H is in a circular shape. For example, the opening 25H and the projecting portion 21P have similar shapes, and an inner surface of the opening 25H and an outer surface of the projecting portion 21P are in contact.

As described above, in the surface emitting laser 30 of Embodiment 3, the groove 15G is formed to pass through the active layer 19. In other words, the groove 15G forms the clearance in the active layer 19. This groove 15G is formed after the semiconductor structure layer 15 is formed. Afterwards, the insulating layer 25 is formed before the light transmissive electrode layer 31, the p-electrode 27, and the second multilayer reflector 29 are formed.

Accordingly, after the semiconductor structure layer 15 is formed, forming the groove 15G that reaches the active layer 19 forms a space or the clearance in a direction along an in-plane of the active layer 19. This clearance reduces a distortion generated in a layer surface direction of the active layer 19 or in a layer surface direction of the semiconductor structure layer 15 when the active layer 19 is formed.

Specifically speaking, the active layer 19 has a crystalline structure distorted by a difference of lattice constants between InGaN and GaN forming the quantum well structure when the active layer 19 is formed to cause a piezoelectric polarization to cause a piezoelectric field. The generation of this piezoelectric field lowers a recombination probability of electrons and holes injected to the active layer 19 to contribute to lower an internal quantum efficiency.

In the surface emitting laser 30, the groove 15G reaching the active layer 19 is formed in the semiconductor structure layer 15. The clearance by this groove is thought to reduce the distortion generated in the in-layer direction of the active layer 19 in the growth of the active layer 19, and thus, the internal quantum efficiency in the active layer 19 improves.

Here, an operation of the surface emitting laser 30 will be described. When a voltage is applied between the n-electrode 23 and the p-electrode 27 in the surface emitting laser 30, a current flows in the semiconductor structure layer 15 as indicated by the two-dot chain bold line in the drawing, and the light is emitted from the active layer 19. The light emitted from the active layer 19 is repeatedly reflected between the first multilayer reflector 13 and the second multilayer reflector 29 to become a resonant state (to laser oscillate).

In the surface emitting laser 30, the current is injected only from a portion exposed by the opening 25H to the p-type semiconductor layer 21. Since the p-type semiconductor layer 21 is considerably thin, the current hardly spreads in the in-plane direction, that is, the direction along the in-plane of the semiconductor structure layer 15 within the p-type semiconductor layer 21. Accordingly, in the surface emitting laser 30, the current is supplied only to the region immediately below the opening 25H in the active layer 19, and the light is emitted only from this region. That is, in the surface emitting laser 30, the opening 25H has the current confinement structure that restricts the supply range of the current in the active layer 19.

As described above, in the embodiment, the first multilayer reflector 13 has a reflectivity slightly lower than that of the second multilayer reflector 29. Accordingly, the light resonated between the first multilayer reflector 13 and the second multilayer reflector 29 partially transmits through the first multilayer reflector 13 and the substrate 11 to be taken out to the outside. Thus, the surface emitting laser 30 emits a light from the lower surface of the substrate 11 toward the direction perpendicular to the lower surface of the substrate 11 and the in-plane directions of the respective layers of the semiconductor structure layer 15.

Note that the projecting portion 21P of the p-type semiconductor layer 21 of the semiconductor structure layer 15 and the opening 25H of the insulating layer 25 define the luminescence center as the center of the light emission region in the active layer 19 to define the center axis (the luminescence center axis) AX of the resonator OC. The center axis AX of the resonator OC passes through the center of the projecting portion 21P of the p-type semiconductor layer 21 and extends along the direction perpendicular to the in-plane direction of the semiconductor structure layer 15.

Note that the light emission region of the active layer 19 means, for example, a region having a predetermined width from which a light having a predetermined intensity or more is emitted in the active layer 19, and its center is the luminescence center. For example, the light emission region of the active layer 19 is a region to which a current having a predetermined density or more is injected in the active layer 19, and its center is the luminescence center. The straight line perpendicular to the upper surface of the substrate 11 passing through the luminescence center or the in-plane directions of the respective layers of the semiconductor structure layer 15 is the center axis AX. The luminescence center axis AX is a straight line extending along a resonator length direction of the resonator OC constituted of the first multilayer reflector 13 and the second multilayer reflector 29. The center axis AX corresponds to an optical axis of the laser light emitted from the surface emitting laser 30.

Here, exemplary configurations of respective layers of the first multilayer reflector 13, the semiconductor structure layer 15, and the second multilayer reflector 29 in the surface emitting laser 30 and exemplary dimensions of the groove 15G will be described. In the embodiment, the first multilayer reflector 13 is made of a GaN base layer of 1 µm formed on the upper surface of the substrate 11 and 42 pairs of n-GaN layers and AlInN layers.

The n-type semiconductor layer 17 is an n-GaN layer having a layer thickness of 1580 nm. The active layer 19 is made of an active layer having a multiple quantum well structure in which four pairs of InGaN layers of 4 nm and GaN layers of 5 nm are laminated. On the active layer 19, the AlGaN electronic barrier layer doped with Mg is formed, and the p-type semiconductor layer 21 made of a p-GaN layer of 50 nm is formed thereon. The second multilayer reflector 29 is a lamination of 10.5 pairs of Nb₂O₅ and SiO₂. The resonant wavelength in this case was 440 nm.

The groove 15G formed on the semiconductor structure layer 15 has an outer diameter of 8 µm, a depth of 120 nm, and a width of 2 µm. Note that the light transmissive electrode layer 31 formed on the semiconductor structure layer 15 is a layer made of ITO of 20 nm, and has the second multilayer reflector 29 formed on the light transmissive electrode layer 31 and the p-electrode 27 with a spacer layer of Nb₂O₅ of 40 nm interposed.

The back surface of the substrate 11 is a polished surface, and two layers of AR coatings of Nb₂O₅ and SiO₂ are formed on this polished surface.

The p-type semiconductor layer 21 may have a layer thickness of 50 nm in the projecting portion 21P and a layer thickness of 30 nm in the other regions. That is, the p-type semiconductor layer 21 may have different layer thicknesses in the projecting portion 21P and the other portions. The insulating layer 25 has the upper surface configured to be arranged at a height position identical to the upper surface of the projecting portion 21P of the p-type semiconductor layer 21.

Note that, in Fig. 9, the groove 15G is illustrated such that the groove 15G is formed in the perpendicular direction with respect to the upper surface of the p-type semiconductor layer 21. However, the groove 15G and the p-type semiconductor layer 21, the insulating layer 25, the light transmissive electrode layer 31, and the p-electrode 27 in the portion of the groove 15G are preferred to be level differences having a side surface inclined with respect to the center axis AX of the surface emitting laser 30. The inclination angle of the side surface is preferred to be 45° or more with respect to the center axis AX. In other words, the inclination angle of the side surface is preferred to be 45° or less with respect to the upper surface of the semiconductor structure layer 15. Providing the inclination in the level difference ensures achieving improved reliability over a long period, such as a crack resistance of the light transmissive electrode layer 31 during a long period of energization.

Note that the surface emitting laser 30 of this embodiment described above is merely an example.

The following describes optical features inside the surface emitting laser 30. As described above, in the surface emitting laser 30, the insulating layer 25 has a refractive index lower than that of the p-type semiconductor layer 21. The layer thicknesses of the other layers between the first multilayer reflector 13 and the second multilayer reflector 29 are the same at any positions in plane insofar as in the same layer.

Accordingly, an equivalent refractive index (an optical distance between the first multilayer reflector 13 and the second multilayer reflector 29, and corresponds to a resonant wavelength) in the resonator OC formed between the first multilayer reflector 13 and the second multilayer reflector 29 of the surface emitting laser 30 differs in the central region CA in a column shape having the upper surface defined by the opening 25H and in the peripheral region PA in a pipe shape around the central region CA by a difference in refractive indexes between the p-type semiconductor layer 21 and the insulating layer 25.

Specifically, the equivalent refractive index in the peripheral region PA is lower than the equivalent refractive index in the central region CA, that is, an equivalent resonant wavelength in the central region CA is smaller than an equivalent resonant wavelength in the peripheral region PA between the first multilayer reflector 13 and the second multilayer reflector 29. Note that, as described above, where the light is emitted in the active layer 19 is the region immediately below the opening 25H. That is, the light emission region where the light is emitted in the active layer 19 is a portion overlapping with the central region CA in the active layer 19.

Note that in Embodiment 3, it has been described the case where the groove 15G is formed into a ring shape outside the central region CA in top view. However, the groove 15G may have a ditch structure including a depressed portion formed intermittently instead of a perfect ring shape. That is, the groove 15G may have a depressed structure including a plurality of the depressed portions. In other words, the groove 15G may have a ring-shaped structure formed intermittently. For example, the groove 15G has a ring-shaped structure that surrounds a region exposed by the opening 25H on the upper surface of the p-type semiconductor layer 21 and is formed intermittently.

Note that, when the groove 15G is formed of the plurality of depressed portions, it is preferred to be formed in two directions or more when viewed from the above-described luminescence center axis AX in order to equally reduce the distortion in the active layer 19. That is, when the groove 15G is formed of the plurality of depressed portions, it is preferred to provide a structure in which the depressed portions are formed in two directions or more when viewed from the light emission region including the luminescence center axis AX in top view of the surface emitting laser 30 and the depressed portions sandwich the light emission region. In order to equally reduce the distortion in the active layer 19, it is further preferred to arrange the depressed portions forming the groove 15G to be rotationally symmetric with respect to the luminescence center axis AX. In other words, it is preferred that the depressed portions forming the groove 15G are disposed to be rotationally symmetric when viewed from the direction perpendicular to the in-plane direction of the semiconductor structure layer 15.

That is, the level difference of the surface emitting laser 30 of Embodiment 3 has one depressed structure including one or a plurality of the grooves 15G that pass through the active layer 19 from the upper surface in the region surrounding the central region CA of the semiconductor structure layer 15. The p-electrode 27 is formed to cover the inner surface of the one or the plurality of grooves 15G.

Note that, as described above, changing the shape of the groove 15G, such as forming the groove 15G with the plurality of depressed portions, also ensures controlling polarization of the light emitted from the surface emitting laser of the above-described embodiment.

According to Embodiment 3, the light transmissive electrode layer 31 on the groove 15G is covered with the p-electrode 27 as the metal layer. This ensures preventing a failure, such as a crack, from occurring in the level difference portion of the light transmissive electrode layer 31 during a long period of energization. Even if a crack occurs in the level difference portion of the light transmissive electrode layer 31 during a long period of energization, since the p-electrode 27 is formed to cover the level difference, the conduction between the p-electrode 27 and the p-type semiconductor layer 21 is maintained. Accordingly, even when a crack occurs in the level difference portion of the light transmissive electrode layer 31, it is possible to prevent a failure, such as an open circuit, from occurring.

Accordingly, with Embodiment 3, it is possible to prevent an increased driving voltage and/or a defect of short circuit/open circuit, during a long period of energization from occurring, and thus, the long-life vertical cavity-type surface emitting laser 30 can be provided.

In addition, as described above, in the surface emitting laser 30 of the embodiment, the groove 15G that reaches the active layer 19 from the upper surface of the p-type semiconductor layer 21 is formed on the semiconductor structure layer 15. With this groove 15G, the distortion generated in the in-layer direction of the active layer 19 is reduced in the active layer 19 to improve the internal quantum efficiency in the active layer 19, thereby ensuring achieving improved luminous efficiency.

Note that in any embodiment of Embodiments 1, 2, and 3, it has been described the case where the level difference 15S or 25S, or the groove 15G is disposed outside the second multilayer reflector 29 from the center axis AX, and the level difference 15S or 25S, or the groove 15G is exposed in top view of the surface emitting laser. However, the level difference 15S or 25S, or the groove 15G may be disposed to be covered with the second multilayer reflector 29.

Even in the configuration where the second multilayer reflector 29 is formed to cover the level difference 15S or 25S, or the groove 15G, a similar effect to those of the respective embodiments can be obtained. In the case of the structure with the groove 15G as in Embodiment 3, the second multilayer reflector 29 is formed to fill the space formed of the groove 15G.

In any embodiment of Embodiments 1, 2, and 3, it has been described the surface emitting laser in which the n-electrode 23 is formed on the upper surface of the substrate 11. However, the n-electrode 23 may be formed on a back surface of the substrate 11. In this case, it is only necessary to form the n-electrode made of metal on the back surface of the substrate 11 using the substrate 11 made of a material such as conductive n-GaN.

In this respect, a back surface projecting portion is formed on the back surface of the substrate 11. The back surface projecting portion is formed in a region corresponding to the projecting portion 21P when viewed from a normal line direction of the substrate 11. This back surface projecting portion is a protrusion remained due to a removal of a peripheral area of the back surface projecting portion by dry etching after the back surface is polished. Accordingly, a top surface of the back surface projecting portion is a polished surface, and the peripheral area of the back surface projecting portion on the back surface of the substrate 11 is a surface formed by dry etching the polished surface. The n-electrode is formed in the peripheral area of the back surface projecting portion, that is, the region excluding the back surface projecting portion. Because the back surface projecting portion of the substrate 11 has a top surface serving as an opening through which the emitted light is emitted outside so as not to obstructing the emitted light by the n-electrode. That is, the back surface projecting portion has a structure in which it projects from the opening of the n-electrode.

That is, the substrate 11 includes the n-type conductivity type, and the surface emitting lasers 10, 20, and 30 have the n-electrode on the surface on the opposite side of the semiconductor structure layer 15 of the substrate 11 and at the portion excluding the region corresponding to the central region CA when viewed from the direction perpendicular to the upper surface of the substrate 11.

In any embodiment of Embodiments 1, 2, and 3, it has been described the surface emitting laser having the current confinement structure by the insulating layer 25 or the deactivation region layer 21A. However, the configuration of the current confinement structure is not limited to these.

For example, the surface emitting laser may be configured to have the current confinement structure of a tunnel joining layer in which a high-doped p-type semiconductor layer having an impurity concentration higher than that of the p-type semiconductor layer 21 and a high-doped n-type semiconductor layer that is formed on the high-doped p-type semiconductor layer and has an impurity concentration higher than that of the n-type semiconductor layer 17 are formed in the central region CA on the p-type semiconductor layer 21.

In other words, in the region outside the central region CA, it is only necessary to be disposed on the layer below the light transmissive electrode layer 31, the level difference in this potion thereof forms a level difference in the light transmissive electrode layer 31, and the p-electrode 27 is formed to cover the level difference portion of the light transmissive electrode layer 31.

Any embodiment of Embodiments 1, 2, and 3 may include a light guide layer including a first transmissive insulating layer that is disposed across the central region CA and the peripheral region PA on the light transmissive electrode layer 31 and has an protrusion on the center axis AX and a second transmissive insulating layer that is disposed on the first transmissive insulating layer in the peripheral region PA and has a refractive index smaller than that of the first transmissive insulating layer.

This reduces an optical loss, which is the standing wave inside the resonator OC being diffused (radiated) outside from the central region CA. That is, a large quantity of light remains in the central region CA and the laser light is taken out to the outside in this state. Accordingly, the large quantity of light concentrates proximity of the center axis AX, and therefore, the laser light having monomodal or multimodal intensity distribution can be stably generated and emitted.

In any embodiment of Embodiments 1, 2, and 3, it has been described the case where the p-electrode 27 covers the level difference of the light transmissive electrode layer 31 and is integrally formed. However, the p-electrode 27 may have a first p-electrode that covers the level difference portion of the light transmissive electrode layer 31 to achieve a long life of the light transmissive electrode layer 31 and a second p-electrode formed at an outer circumference of the semiconductor structure layer 15 and electrically connected to a mounting board. In other words, the p-electrode 27 may be separated into a portion that protects the light transmissive electrode layer 31 and a portion that is connected to the mounting board.

In any embodiment of Embodiments 1, 2, and 3, it has been described the case where the p-electrode 27 is formed to cover the level difference of the light transmissive electrode layer 31. However, a protective film that covers the level difference of the light transmissive electrode layer 31 is not limited to the p-electrode 27.

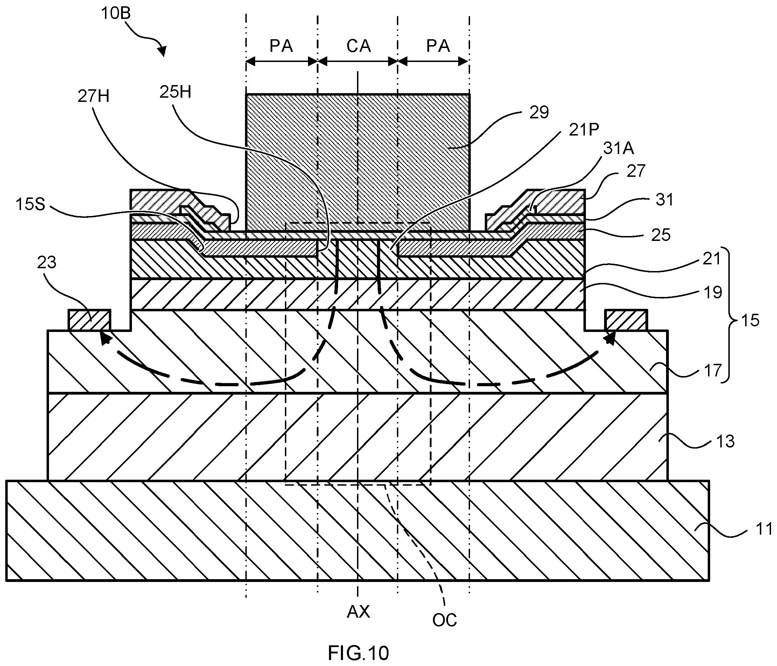

Fig. 10 illustrates a cross-sectional view of a surface emitting laser 10B according to Modification 3 of Embodiment 1.

For example, as illustrated in Fig. 10, a second light transmissive electrode layer 31A having the same material as that of the light transmissive electrode layer 31 may be additionally laminated only on the level difference portion of the light transmissive electrode layer 31. In other words, a film thickness of the level difference portion of the light transmissive electrode layer 31 may be, for example, double the film thickness of the light transmissive electrode layer 31. This can cause the generation of a crack in the level difference portion of the light transmissive electrode layer 31 during a long period of energization to be less likely to occur. Note that, while in the modification, it has been described the case where the second light transmissive electrode layer 31A is additionally laminated only on the portion equivalent to the level difference 15S, the range where the second light transmissive electrode layer 31A is laminated is not limited to this. For example, the second light transmissive electrode layer 31A may be formed in the range excluding the central region CA as the light emission region. In other words, it is only necessary to be formed to cover the portion equivalent to at least the level difference 15S. Modification 3 is also applicable in Embodiments 2 and 3.

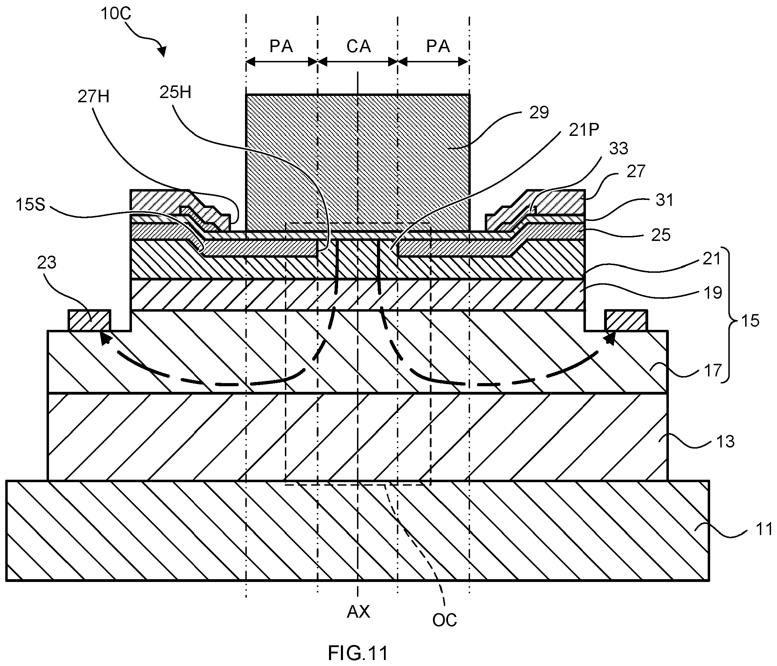

Fig. 11 illustrates a cross-sectional view of a surface emitting laser 10C according to Modification 4 of Embodiment 1.

Similarly to Modification 2, a dielectric layer 33 may be formed only in the level difference portion of the light transmissive electrode layer 31. The dielectric layer 33 is, for example, a dielectric film formed of a material such as SiO₂, SiNₓ, or Al₂O₃. Note that the dielectric layer 33 is preferred to be a dielectric film having a reactivity to the light transmissive electrode layer 31 lower than that of the high refractive index dielectric film (Nb₂O₅ in this embodiments) used for the spacer layer (not illustrated). As described above, protecting the level difference portion of the light transmissive electrode layer 31 with a dielectric layer can cause the generation of a crack in the level difference portion of the light transmissive electrode layer 31 during a long period of energization to be less likely to occur. Note that, while in the modification, it has been described the case where the dielectric layer 33 is additionally laminated only on the portion equivalent to the level difference 15S, the range where the dielectric layer 33 is laminated is not limited to this. For example, the dielectric layer 33 may be formed in a range excluding the central region CA as the light emission region. In other words, it is only necessary to be formed to cover the portion equivalent to at least the level difference 15S. However, in this case, the dielectric layer 33 is preferred to be formed so as not to inhibit the electrical contact between the p-electrode 27 and the light transmissive electrode layer 31. That is, it is preferred that the p-electrode 27 and the light transmissive electrode layer 31 are configured to be electrically in contact in at least one portion. Modification 4 is also applicable in embodiments 2 and 3.

Various values, dimensions, materials, and the like in Embodiments and Modifications described above are merely examples, and can be appropriately selected corresponding to the usage and the fabricated surface emitting laser.

## Claims

1. A vertical cavity light-emitting element (10) comprising:
a substrate (11) that is a gallium-nitride-based semiconductor;
a first multilayer reflector (13) made of a nitride semiconductor formed on the substrate (11);
a semiconductor structure layer (15) including a first semiconductor layer (17), an active layer (19), and a second semiconductor layer (21), the first semiconductor layer (17) being made of a nitride semiconductor having a first conductivity type formed on the first multilayer reflector (13), the active layer (19) being made of a nitride semiconductor formed on the first semiconductor layer (17), the second semiconductor layer (21) being formed on the active layer (19) and made of a nitride semiconductor having a second conductivity type opposite of the first conductivity type;
a light transmissive electrode layer (31) formed on an upper surface of the second semiconductor layer (21), the light transmissive electrode layer (31) being electrically in contact with the second semiconductor layer (21) in one region (21P) of the second semiconductor layer (21) and being insulated from the second semiconductor layer (21) in another region that is other than the one region (21P) and surrounds the one region (21P);
a light transmissive insulating layer (25) disposed between the second semiconductor layer (21) and the light transmissive electrode layer (31) in said another region that surrounds the one region (21P) of the second semiconductor layer to insulate the light transmissive electrode layer (31) from the second semiconductor layer (21);
a metal conductor layer (27) formed on an upper surface of the light transmissive electrode layer (31) above said another region; and
a second multilayer reflector (29) formed on the light transmissive electrode layer (31) to cover the one region (21P), the second multilayer reflector (29) configuring a resonator between the first multilayer reflector (13) and the second multilayer reflector (29),
**characterized in that**
said another region of the upper surface of the semiconductor layer (21) includes a level difference (15S) formed outside the second multilayer reflector (29);
in a region inside the level difference (15S),
the upper surface of the light transmissive insulating layer (25) and the upper surface of the one region (21P) have a flatness characteristic;
the metal conductor layer (27) is formed to cover the light transmissive electrode layer (31) on the level difference (158) ;
the level difference (15S) has an inclined surface with respect to the center axis (AX) of the semiconductor structure layer (15); and
a central region (CA) corresponding to the one region (21P) of the resonator configured between the first multilayer reflector (13) and the second multilayer reflector (29) has an equivalent refractive index higher than that of a peripheral region (PA) in said another region of the resonator configured between the first multilayer reflector (13) and the second multilayer reflector (29).

2. The vertical cavity light-emitting element according to claim 1, wherein
the inclined surface of the level difference (15S) has an angle with respect to the upper surface of the semiconductor structure layer (15) of 45° or less.

3. The vertical cavity light-emitting element according to any one of claims 1 to 2, wherein
the first semiconductor layer (17) has an upper surface having a mesa-shaped structure, and the active layer (19) and the second semiconductor layer (21) are laminated on the mesa-shaped structure, and
the vertical cavity light-emitting element (10) has a n-electrode layer (23) electrically in contact with the first semiconductor layer (17) on the upper surface of the first semiconductor layer (17) that exists around the mesa-shaped structure.

4. The vertical cavity light-emitting element according to any one of claims 1 to 3, wherein
the substrate (11) includes the first conductivity type, and
the vertical cavity light-emitting element (10) has a n-electrode layer (23) arranged on a surface of the semiconductor structure layer (15) on a side opposite to the substrate (11) and at a position excluding a region corresponding to the one region (21P) when viewed from a direction perpendicular to an upper surface of the substrate (11).

## Patentansprüche

1. Oberflächenlichtemitterelement (10), das Folgendes aufweist:
ein Substrat (11), das ein Halbleiter auf Galliumnitrid-Basis ist;
einen ersten Mehrschicht- bzw. Multilayer-Reflektor (13), der aus einem Nitridhalbleiter gemacht ist, der auf dem Substrat (11) geformt ist;
eine Halbleiterstrukturschicht (15), die eine erste Halbleiterschicht (17), eine aktive Schicht (19) und eine zweite Halbleiterschicht (21) aufweist, wobei die erste Halbleiterschicht (17), die aus einem Nitridhalbleiter eines ersten Leitfähigkeitstyps gemacht ist, auf dem ersten Multilayer-Reflektor (13) geformt ist, wobei die aktive Schicht (19), die aus einem Nitridhalbleiter gemacht ist, auf der ersten Halbleiterschicht (17) geformt ist, wobei die zweite Halbleiterschicht (21), die auf der aktiven Schicht (19) geformt ist und aus einem Nitridhalbleiter gemacht ist, einen zweiten Leitfähigkeitstyp hat, der dem ersten Leitfähigkeitstyp entgegengesetzt ist;
eine lichtdurchlässige Elektrodenschicht (31), die auf einer Oberseite der zweiten Halbleiterschicht (21) geformt ist, wobei die lichtdurchlässige Elektrodenschicht (31) in einer Region (21P) der zweiten Halbleiterschicht (21) elektrisch mit der zweiten Halbleiterschicht (21) in Kontakt steht und in einer anderen Region, die von der einen Region (21P) verschieden ist und die eine Region (21P) umgibt, von der zweiten Halbleiterschicht (21) isoliert ist;
eine lichtdurchlässige Isolierschicht (25), die zwischen der zweiten Halbleiterschicht (21) und der lichtdurchlässigen Elektrodenschicht (31) in der anderen Region angeordnet ist, welche die eine Region (21P) der zweiten Halbleiterschicht umgibt, um die lichtdurchlässige Elektrodenschicht (31) von der zweiten Halbleiterschicht (21) zu isolieren;
eine Metallleiterschicht (27), die auf einer Oberseite der lichtdurchlässigen Elektrodenschicht (31) über jener anderen Region geformt ist; und
einen zweiten Mehrschicht- bzw. Multilayer-Reflektor (29), der auf der lichtdurchlässigen Elektrodenschicht (31) geformt ist, so dass er die eine Region (21P) bedeckt, wobei der zweite Multilayer-Reflektor (29) einen Resonator zwischen dem ersten Multilayer-Reflektor (13) und dem zweiten Multilayer-Reflektor (29) konfiguriert bzw. bildet,
**dadurch gekennzeichnet, dass**
die andere Region der Oberseite der Halbleiterschicht (21) einen Höhenunterschied (15S) aufweist, der außerhalb des zweiten Multilayer-Reflektor (29) geformt ist;
wobei in einer Region innerhalb des Höhenunterschieds (15S) die Oberseite der lichtdurchlässigen Isolierschicht (25) und die Oberseite der einen Region (21P) eine flache Charakteristik aufweisen;
die Metallleiterschicht (27) so geformt ist, dass sie die lichtdurchlässige Elektrodenschicht (31) an dem Höhenunterschied (15S) bedeckt;
der Höhenunterschied (15S) eine bezüglich der Mittelachse (AX) der Halbleiterstrukturschicht (15) geneigte Fläche aufweist; und
eine mittige Region (CA), die der einen Region (21P) des Resonators entspricht, der zwischen dem ersten Multilayer-Reflektor (13) und dem zweiten Multilayer-Reflektor (29) konfiguriert ist, einen äquivalenten Brechungsindex aufweist, der höher ist als der einer Umfangsregion (PA) in der anderen Region des Resonators, der zwischen dem ersten Multilayer-Reflektor (13) und dem zweiten Multilayer-Reflektor (29) konfiguriert bzw. gebildet ist.

2. Oberflächenlichtemitterelement nach Anspruch 1, wobei
die geneigte Fläche des Höhenunterschieds (15S) einen Winkel von 45° oder weniger bezüglich der Oberseite der Halbleiterstrukturschicht (15) aufweist.

3. Oberflächenlichtemitterelement nach einem der Ansprüche 1 bis 2,
wobei die erste Halbleiterschicht (17) eine Oberseite mit einer plateauförmigen Struktur aufweist, und wobei die aktive Schicht (19) und die zweite Halbleiterschicht (21) auf der plateauförmigen Struktur laminiert bzw. geschichtet sind, und
wobei das Oberflächenlichtemitterelement (10) eine n-Elektrodenschicht (23) aufweist, die mit der ersten Halbleiterschicht (17) auf der Oberseite der ersten Halbleiterschicht (17) in elektrischem Kontakt steht, welche um die plateauförmige Struktur herum vorhanden ist.

4. Oberflächenlichtemitterelement nach einem der Ansprüche 1 bis 3,
wobei das Substrat (11) den ersten Leitfähigkeitstyp aufweist, und
wobei das Oberflächenlichtemitterelement (10) eine n-Elektrodenschicht (23) aufweist, die auf einer Oberfläche der Halbleiterstrukturschicht (15) auf der dem Substrat (11) gegenüberliegenden Seite angeordnet ist, und zwar an einer Position, die in einer Ansicht aus einer Richtung senkrecht zu einer Oberseite des Substrates (11) eine Region ausspart, die der einen Region (21P) entspricht.

## Revendications

1. Élément électroluminescent à cavité verticale (10), comprenant :
un substrat (11) qui est un semiconducteur à base de nitrure de gallium ;
un premier réflecteur multicouche (13) constitué d'un semiconducteur nitruré formé sur le substrat (11) ;
une couche de structure semiconductrice (15) comportant une première couche semiconductrice (17), une couche active (19) et une deuxième couche semiconductrice (21), la première couche semiconductrice (17) étant constituée d'un semiconducteur nitruré ayant un premier type de conductivité formé sur le premier réflecteur multicouche (13), la couche active (19) étant constituée d'un semiconducteur nitruré formé sur la première couche semiconductrice (17), la deuxième couche semiconductrice (21) étant formée sur la couche active (19) et constituée d'un semiconducteur nitruré ayant un deuxième type de conductivité opposé au premier type de conductivité ;
une couche d'électrode transmettant la lumière (31) formée sur une surface supérieure de la deuxième couche semiconductrice (21), la couche d'électrode transmettant la lumière (31) étant en contact électrique avec la deuxième couche semiconductrice (21) dans une région (21P) de la deuxième couche semiconductrice (21) et étant isolée de la deuxième couche semiconductrice (21) dans une autre région qui est différente de l'une région (21P) et entoure l'une région (21P) ;
une couche d'isolant transmettant la lumière (25) disposée entre la deuxième couche semiconductrice (21) et la couche d'électrode transmettant la lumière (31) dans ladite autre région qui entoure l'une région (21P) de la deuxième couche semiconductrice pour isoler la couche d'électrode transmettant la lumière (31) de la deuxième couche semiconductrice (21) ;
une couche conductrice métallique (27) formée sur une surface supérieure de la couche d'électrode transmettant la lumière (31), au-dessus de ladite autre région ; et
un deuxième réflecteur multicouche (29) formé sur la couche d'électrode transmettant la lumière (31) pour recouvrir l'une région (21P), le deuxième réflecteur multicouche (29) configurant un résonateur entre le premier réflecteur multicouche (13) et le deuxième réflecteur multicouche (29),
**caractérisé en ce que**
ladite autre région de la surface supérieure de la couche semiconductrice (21) comporte une différence de niveau (15S) formée à l'extérieur du deuxième réflecteur multicouche (29) ;
dans une région interne à la différence de niveau (15S), la surface supérieure de la couche d'isolant transmettant la lumière (25) et la surface supérieure de l'une région (21P) ont une caractéristique d'horizontalité ;
la couche conductrice métallique (27) est formée pour recouvrir la couche d'électrode transmettant la lumière (31) sur la différence de niveau (15S) ;
la différence de niveau (15S) a une surface inclinée par rapport à l'axe central (AX) de la couche de structure semiconductrice (15) ; et
une région centrale (CA) correspondant à l'une région (21P) du résonateur configurée entre le premier réflecteur multicouche (13) et le deuxième réflecteur multicouche (29) configurant un résonateur entre le premier réflecteur multicouche (13) et le deuxième réflecteur multicouche (29) a un indice de réfraction équivalent supérieur à celui d'une région périphérique (PA) dans ladite autre région du résonnateur configurée entre le premier réflecteur multicouche (13) et le deuxième réflecteur multicouche (29).

2. Élément électroluminescent à cavité verticale selon la revendication 1, dans lequel la surface inclinée de la différence de niveau (15S) a un angle par rapport à la surface supérieure de la couche de structure semiconductrice (15) de 45° ou moins.

3. Élément électroluminescent à cavité verticale selon l'une quelconque des revendications 1 à 2, dans lequel
la première couche semiconductrice (17) a une surface supérieure ayant une structure en forme de mesa, et la couche active (19) et la deuxième couche semiconductrice (21) sont laminées sur la structure en forme de mesa, et
l'élément électroluminescent à cavité verticale (10) a une couche à n électrodes en contact électrique avec la première couche semiconductrice (17) sur la surface supérieure de la première couche semiconductrice (17) qui existe autour de la structure en forme de mesa.

4. Élément électroluminescent à cavité verticale selon l'une quelconque des revendications 1 à 3, dans lequel
le substrat (11) comporte le premier type de conductivité, et
l'élément électroluminescent à cavité verticale (10) a une couche à n électrodes (23) disposée sur une surface de la couche de structure semiconductrice (15) du côté opposé au substrat (11) et à une position excluant une région correspondant à l'une région (21P) lorsqu'elle est vue d'une direction perpendiculaire à une surface supérieure du substrat (11).
